# EUROPÄISCHE PATENTSCHRIFT

(11) **EP 1 108 273 B1**
(45) Veröffentlichungstag und Bekanntmachung des Hinweises auf die Patenterteilung: **19.02.2003**
(21) Anmeldenummer: 99953537.0
(22) Anmeldetag: 19.08.1999
(51) Int. Cl.: H01R 13/703

(54) **EXPLOSIONSGESCHÜTZTE STECKVERBINDUNGSANORDNUNG**
EXPLOSION-PROOF PLUG-IN CONNECTOR
ENSEMBLE CONNECTEUR MALE-FEMELLE ANTI-EXPLOSION

(30) Priorität: 25.08.1998 DE 19838492
(43) Veröffentlichungstag der Anmeldung: 20.06.2001
(73) Patentinhaber: R. Stahl Schaltgeräte GmbH, D-74653 Künzelsau (DE)
(72) Erfinder: RAPP, Jürgen, D-74653 Morsbach (DE)
(74) Vertreter: Patentanwälte Rüger, Barthelt & Abel
(86) Internationale Anmeldenummer: DE9902603
(87) Internationale Veröffentlichungsnummer: WO00011758

(56) Entgegenhaltungen:
- EP-A- 0 603 026
- DE-A- 3 212 983
- GB-A- 2 214 004
- PATENT ABSTRACTS OF JAPAN vol. 14, no. 584 (E-1018), 27. Dezember 1990 (1990-12-27) & JP 02 254919 A (MITSUBISHI ELECTRIC CORP), 15. Oktober 1990 (1990-10-15)

## Beschreibung

Aus der EP 0 261 307 ist ein explosionsgeschütztes Modulgehäuse bekannt, das in explosionsgefährdeten Bereichen angeordnet werden kann und dazu vorgesehen ist, mit weiteren gleichen Modulgehäusen zusammen in ein Gestell eingesetzt zu werden. Zur elektrischen Verbindung der Modulgehäuse untereinander bzw. mit einer oder mehreren Stromversorgungen sind an jedem Modulgehäuse zwei Arten von Steckverbindergruppen vorgesehen.

Die eine Gruppe wird von Steckerstiften einer handelsüblichen Steckerleiste gebildet, die mit einer ebenfalls handelsüblichen Buchsenleiste im Gestell elektrisch und mechanisch zusammenwirken. Über diese Kontaktstellen werden sämtliche eigensichere Stromkreise geführt.

Eigensichere Stromkreise im Sinne des Explosionsschutzes sind Stromkreise, bei denen die Spannung gegenüber einem anderen stromführenden Leiter unterhalb eines vorbestimmten Spannungsgrenzwertes liegt, der von den zu erwartenden zündfähigen Gasgemischen abhängig ist. Außerdem muss zwangsläufig sichergestellt sein, dass auf eigensicheren Stromkreisen der Strom unter einer vorbestimmten Grenze bleibt, die ebenfalls von der Zündfähigkeit des zu erwartenden Gemisches abhängig ist.

Da diese Bedingung nicht notwendigerweise auch für die Stromversorgung gilt, denn hier ist die Spannung und/oder der maximal zulässige Strom, häufig größer als die Grenzwerte für die Zündschutzart "Eigensicherheit", werden diese nichteigensicheren Stromkreise über Sondersteckverbinder geleitet, die zu der anderen Gruppe gehören.

Die Sondersteckverbinder bestehen wiederum aus einer Steckerleiste an dem Modulgehäuse und einer Buchsenleiste im Gestell. Sie sind jedoch so gestaltet, dass der Steckerstift in der Buchsenleiste von einem Kontaktraum umschlossen ist, der bei eingeführtem Stecker die Bedingungen für die Zündschutzart "Druckfeste Kapselung" erfüllt. Hierzu muss der Spalt zwischen der Bohrung in dem Isolierkörper für die Buchse und einer isolierenden Ummantelung des Steckerstiftes die Bedingungen des "Ex-Spaltes" erfüllen. Da diese Toleranzen relativ eng sind, ergibt sich für die Steckverbindermittel der nichteigensicheren Stromkreise ein erheblicher Fertigungs- und Bauaufwand und ein nicht unbeachtlicher Platzbedarf.

Darüber hinaus wird ein zusätzlicher Schalter auf der Gestellseite benötigt, um die Buchsen spannungslos zu schalten, wenn die Steckerstifte aus den Buchsen herausgezogen sind.

Bei einer anderen aus der EP 0 261 307 bekannten Lösung ist die Buchse für einen nichteigensicheren Stromkreis in dem Buchsenträger beweglich gelagert und bildet zusammen mit einem dahinter befindlichen Kontakt einen Schalter, der beim Einstecken bzw. Herausziehen des Steckerstiftes betätigt wird.

Auch diese Lösung ist mechanisch sehr aufwendig und lässt sich nicht beliebig weit miniaturisieren.

Insbesondere eignen sich beide Lösungen nur für Modulgehäuse ab ca. einer Größe, die zur Aufnahme von Leiterplatten im Europa-Format geeignet sind. Sie eignen sich weniger für miniaturisierte Busschienensysteme, einfach aufgrund ihres Platzbedarfes. Darüber hinaus ist die Lösung wegen der nicht handelsüblichen Stecker- und Buchsenleisten verhältnismäßig teuer.

Die DE-A-34 46 396 beschreibt ein explosionsgeschütztes elektrisches Verbindersystem, bei dem die Verbraucherseite mit Steckerstiften und die speisende Seite mit Steckbuchsen versehen ist. Über diese Buchsen und Stecker fließt bei zusammengesteckten Verbindungssystemen der Laststrom. Zusätzlich zu diesen Steckern und Buchsen für den Laststrom sind auf der Verbraucherseite zwei weitere Steckerstifte vorhanden, die galvanisch mit einander verbunden und etwas kürzer ausgebildet sind, als die Steckerstifte für den Laststrom. Diese verkürzten Steckerstifte wirken mit entsprechenden Steckbuchsen des Gegenstücks zusammen, die in dem Steuerstromkreis eines Relais oder Schützen liegen. Über die Schaltkontakte des Relais fließt der Laststrom zu den Laststrombuchsen.

Wenn der Stecker eingesteckt ist, wird der Schütz eingeschaltet und es kann der Laststrom über die Hauptstromsteckerstifte fließen. Beim Herausziehen der Steckereinheit wird zunächst der Steuerstromstromkreis getrennt, wodurch die Hauptstromsteckerstifte spannungslos werden, damit sie sich schließlich ohne die Gefahr eines Öffnungsfunkens aus den Buchsen herausziehen lassen.

Eine ähnliche Anordnung ist in der DE-A-32 12 983 gezeigt, bei der jedoch als schaltendes Element ein Halbleiterschalter vorhanden ist.

Ausgehend hiervon ist es Aufgabe der Erfindung eine Steckverbindungsanordnung zu schaffen, die einen geringen mechanischen Aufwand erfordert, kostengünstiger und/oder raumsparender ist und für sich genommen die Vorschriften des Explosionsschutzes erfüllt.

Diese Aufgabe wird erfindungsgemäß durch die Steckverbindungsanordnung mit den Merkmalen des Anspruches 1 gelöst.

Bei der neuen Lösung können auf der Stromversorgungsund auf der Verbraucherseite einfache Steckverbinder verwendet werden. Soweit die Stromkreise, die über diese Steckverbinder geführt werden, nicht eigensicher sind, ist eine steuerbare Schaltereinrichtung hierzu vorgesehen, die einen Eingang und einen Ausgang aufweist. Diese Schaltereinrichtung ist eingangsseitig an den wenigstens einen Steckerstift oder ausgangsseitig an die wenigstens eine Steckbuchse elektrisch angeschlossen. Die Schaltereinrichtung kennt zwei Betriebszustände, nämlich einen niederohmigen Betriebszustand und einen hochohmigen Betriebszustand, jeweils gemessen zwischen Eingang und Ausgang.

Der Schaltereinrichtung ist eine Steuereinrichtung zugeordnet, die mit einem Steuersignal arbeitet, das von dem jeweils anderen Steckverbindungsteil kommt, und zwar in der Weise, dass die Steuereinrichtung die Schalteinrichtung erst dann in den niederohmigen Zustand bringt, wenn der wenigstens eine Steckerstift mit der wenigstens einen Steckbuchse eine zuverlässige elektrisch leitende Verbindung bildet, während umgekehrt die Schalteinrichtung bereits dann in den hochohmigen Zustand gebracht wird, noch bevor beim Trennen die elektrisch leitende Verbindung zwischen dem Steckerstift und der Steckbuchse aufgetrennt wird.

Zufolge dieser Lösung können an der Trennstelle zwischen Steckbuchse und Steckerstift auf keinen Fall irgendwelche zündfähigen Funken entstehen, da sie immer im stromlosen Zustand miteinander in Verbindung gebracht oder voneinander getrennt werden. Es genügt, wenn die Steckverbindung im gesteckten Zustand zwischen Steckerstift und Steckerbuchse die Anforderungen an die Zündschutzart "Erhöhte Sicherheit" erfüllt oder eine nicht störanfällige Verbindung gemäß den Anforderungen der Zündschutzart "Eigensicherheit" darstellt.

Diese Anforderung können sowohl durch Steckbuchsen oder Stecker mit Vielfachkontaktstellen erzeugt werden, als auch durch einfache Steckbuchsen und Steckerstifte, wenn hiervon mehrere elektrisch parallelgeschaltet sind. Die Sicherheitsvorschriften gehen davon aus, dass in keinem der Fälle sämtliche Kontaktstellen aufgrund von Erschütterungen gleichzeitig Unterbrechungen erleiden, die zu Funken führen könnten.

Bei Verwendung in Busschienensystemen ist es von Vorteil, wenn die Schaltereinrichtung nicht in der Busschiene, sondern auf der Seite des Verbrauchers angeordnet ist.

Die Unterbringung auf der Seite des Verbrauchers schaltet außerdem automatisch die Steckerstifte spannungslos, was dann erforderlich ist, wenn auf der Verbraucherseite Kondensatoren enthalten sind, die unter Umständen über längere Zeit an den Steckerstiften zu erhöhten Spannungen gegenüber anderen Steckerstiften führen. In diesem Falle würden ohne die Schaltereinrichtung durch das Ablegen auf einer elektrisch leitenden Unterlage Entladungsfunken erzeugt werden können.

Um Berührungssicherheit zu gewährleisten, sind die Steckerstifte einzeln oder insgesamt von einem Schutzkragen umgeben. Beim Einführen der Steckerstifte in die Steckbuchsen entsteht eine Situation, in der die einzelnen Steckerstifte bereits Spannung führen, ehe sie vollständig in die Steckbuchsen eingesteckt sind. Um in diesem Zustand die an sich freiliegenden Steckerstifte gegen Berührung zu schützen, sind ein oder mehrere Schutzkragen vorgesehen.

Gleichzeitig können der oder die Schutzkrägen als mechanischer Schutz für die unter Umständen recht filigranen Steckerstifte dienen, wenn der Kragen eine Tiefe aufweist, die größer ist als es der Länge des oder der Steckerstifte entspricht.

Die Herstellung ist sehr einfach, wenn der Kragen an dem Halterteil aus Isolierstoff einstückig angeformt ist.

Der Raumbedarf für die Schaltereinrichtung wird extrem klein, wenn sie als rein elektronische Schalteinrichtung ausgeführt ist. Sie ist zweckmäßigerweise redundant ausgeführt, damit beim Ausfall eines der wichtigen Halbleiter mit Sicherheit der Stromkreis richtig unterbrochen wird.

Das Steuersignal kann in dem Steuerstrom für die Schaltereinrichtung bestehen. Es kommt dann aus dem Steckverbindungsteil, das nicht der Schaltereinrichtung zugeordnet ist, wenn der Steuerstrom wenigstens einmal über die Verbindung zwischen den beiden Steckverbindungsteilen fließt.

Eine besonders zuverlässige und sichere Anordnung wird erreicht, wenn der Steuerstrom zweimal über die beiden Steckverbindungsteile fließt, in der Weise, dass der Strom beispielweise aus der Schaltung des Verbrauchers direkt erhalten wird, wenn die Stromverbindungsanschlüsse für den Verbraucher elektrisch leitend verbunden sind. Der Steuerstromkreis ist in jedem Falle ein eigensicherer Kreis, der keine besonderen Schutzmaßnahmen erfordert.

Die gewünschte zeitliche Relation hinsichtlich der Kontaktgabe lässt sich in einfacher Weise durch die räumliche Anordnung der Steckbuchsen bzw. die Länge der Steckerstifte steuern. Durch verkürzte Steckerstifte für den Steuerstromkreis wird das gewünschte Nacheilen beim Zusammenstecken bzw. das erforderliche Vorauseilen beim Trennen erreicht.

Um die Schaltereinrichtungen zu schützen, ist eine Überlastungsschutzeinrichtung vorgesehen. Es können zusätzliche thermische Sensoren vorhanden sein, die zu einem Abschalten führen, sollte die Schaltereinrichtung unzulässige Temperaturen erreichen. Es ist ebenfalls denkbar, den Strom zu erfassen und die Schaltereinrichtungen zwangsweise in den AUS-Zustand zu bringen, sollte der Strom einen vorbestimmten Grenzwert übersteigen, der deutlich niedriger liegt als der zulässige Grenzwert der Bauelemente.

Im Übrigen sind Weiterbildungen der Erfindung Gegenstand von Unteransprüchen.

In der Zeichnung sind Ausführungsbeispiele des Gegenstandes der Erfindung dargestellt. Es zeigen:
Fig. 1 eine Prinzipdarstellung des mechanischen und des elektronischen Teils der explosionsgeschützten Steckverbindungsanordnung,
Fig. 2 eine Anordnung ähnlich der nach Fig. 1, wobei der Steuerstrom nur einmal über die Steckverbinder fließt und
Fig. 3 eine explosionsgeschützte Steckverbindungsanordnung, bei der die Schaltereinrichtung auf der Stromversorgungsseite angeordnet ist, in einer Darstellung ähnlich wie in Fig. 1.

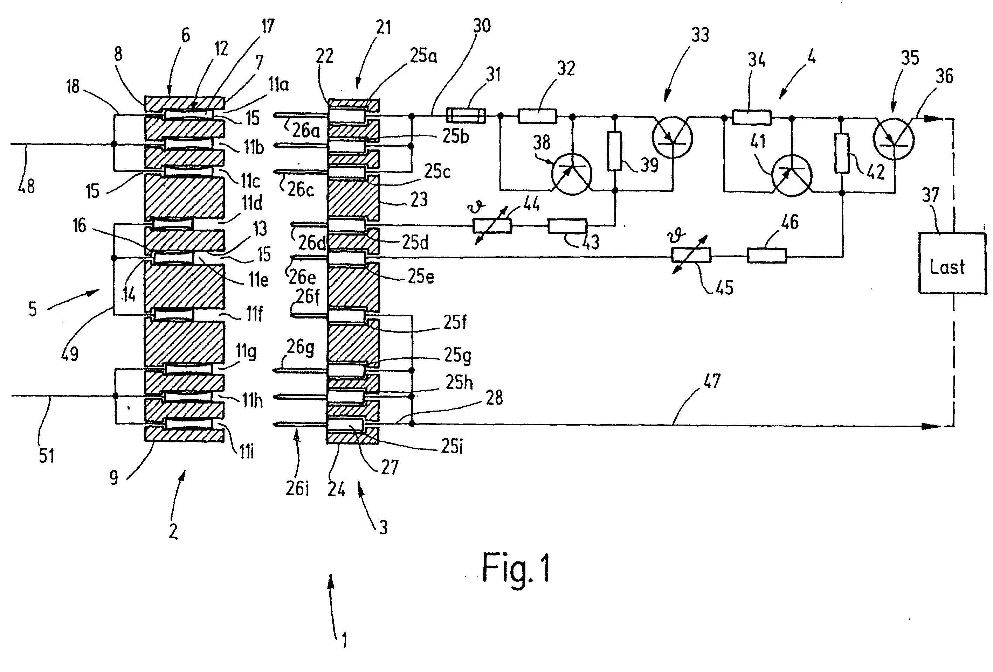

Fig. 1 zeigt eine Prinzipdarstellung einer explosionsgeschützten Steckverbindungsanordnung 1. Zu der Steckverbindungsanordnung 1 gehören zwei Steckverbinder 2 und 3 sowie eine Schaltereinrichtung 4, der eine Steuereinrichtung 5 zugeordnet ist.

Der Steckverbinder 2 besteht aus einem quaderförmigen Halter oder Grundkörper 6, der aus einem Isolierstoff hergestellt ist. Der Grundkörper 6 wird von einer ebenen Vorderseite 7, einer ebenen Rückseite 8 und Seitenflächen 9 begrenzt.

Beim gezeigten Ausführungsbeispiel sind in dem Grundkörper 6 insgesamt neun Durchgangsöffnungen 11a...11i vorhanden, die von der Vorderseite 7 bis zu der Rückseite 8 reichen. Sie dienen als Sitz für darin befindliche Steckbuchsen 12.

Jeder Buchsensitz 11 setzt sich aus einem an die Vorderseite 7 angrenzenden Abschnitt 13 und einem Abschnitt 14 zusammen. Der Abschnitt 13 mündet an der Vorderseite 7 mit einer Einstecköffnung 15, während der Abschnitt 14 an einer Öffnung 15 zu der Rückseite 8 hin offen ist. Der Abschnitt 14 hat einen kleineren Querschnitt als der Abschnitt 13, so dass die beiden Abschnitte 13 und 14 an einer Schulter 16 ineinander übergehen. Die Schultern 16 der Buchsensitze 11d, 11e und 11f ist in Richtung auf die Rückseite 8 hin versetzt, verglichen mit den Schultern 16 der Buchsensitze 11a, 11b, 11c und 11g, 11h und 11i. Auf diese Weise sitzen die darin befindlichen Steckbuchsen 12 etwas tiefer, bezogen auf die Vorderseite 7, als die Steckbuchsen in den Buchsensitzen 11a...11c sowie 11g...11i.

Jede Steckbuchse 12 besteht aus einem metallischen rohrförmigen Abschnitt 17, der an seiner Rückseite in eine Lötfahne übergeht, die durch den Abschnitt 14 des betreffenden Buchsensitzes 11 aus der Rückseite 8 des Trägers 6 heraussteht.

Der Steckverbinderteil 3 besteht ebenfalls aus einem quaderförmigen Grundkörper 21 mit einer Vorderseite 22, einer Rückseite 23 sowie Seitenflächen 24. In dem Grundkörper 21 sind mit den Buchsensitzen 11a...11i fluchtende Sitze 24a...24i enthalten. Die Sitze 24a...24i haben eine ähnliche Form wie die Buchsensitze 11 und reichen von der Vorderseite 22 bis zur Rückseite 23. Da sie eine ähnliche Gestalt haben, wird auf eine erneute ausführliche Erläuterung verzichtet.

In den Sitzen 24a...24i sind metallische Stecker-stifte 26 verankert, die aus der Vorderseite 22 parallel zueinander vorstehen. An der Rückseite gehen die Steckerstifte jeweils in verdickte Grundkörper 27 über, die schließlich in einer Lötfahne 28 enden, die aus der Rückseite des Grundkörpers 21 vorsteht.

Die Steckerstifte 26c...26e haben, gemessen ab der Vorderseite 22, eine etwas geringere Länge als die Steckerstifte 26a...26c bzw. 26g...26i. Dadurch werden beim Einführen der Steckerstifte 26 in die zugehörigen Steckbuchsen 12 zunächst die Steckerstifte 26a...26c und die Steckerstifte 26g...26i mit den zugehörigen Steckbuchsen 12 einen elektrischen Kontakt herstellen, ehe eine elektrisch leitende Verbindung zwischen den Steckerstiften 26c...26f mit den zugehörigen Steckbuchsen 12 in den Buchsensitzen 11d...11f zustandekommt, d.h. die Kontaktgabe der Steckerstifte 26d...26f eilt beim Zusammenstecken nach. Beim Trennen werden umgekehrt die Stromkreise über diese Steckerstifte 26d...26f vorauseilen, d.h. als erste getrennt. Diese Maßnahme alleine würde bereits genügen. Ein Tiefersetzen der Steckbuchsen 12 in den Buchsensitzen 11d..11f ist nicht unbedingt zusätzlich erforderlich.

Die Schaltereinrichtung 4 ist mit ihrem Eingang 30 an die drei elektrisch zueinander parallel geschalteten Steckerstifte 26a...26c angeschlossen. Sie enthält eingangsseitig eine Schmelzsicherung 31, mit der ein Stromfühlerwiderstand 32 in Serie liegt. An den Stromfühlerwiderstand 32 schließt sich, wie gezeigt, eine PNP-Transistor 33 an, dessen Emitter mit dem Widerstand 32 verbunden ist, während sein Kollektor an einen weiteren Stromfühlerwiderstand 34 angeschaltet ist. Mit diesem wiederum liegt ein zweiter PNP-Transistor 35 in Serie, wobei dessen Emitter mit dem Stromfühlerwiderstand 34 verbunden ist. Der Kollektor des Transistors 35 führt über eine Verbindungsleitung 36 zu einer Last oder einem Verbraucher 37.

Parallel zu dem Stromfühlerwiderstand 32 liegt die Basis-Emitterstrecke eines PNP-Transistors 38, und zwar so, dass dessen Emitter an der Verbindungsstelle zwischen der Sicherung 31 und dem Stromfühlerwiderstand 32 angeschlossen ist, während die Basis mit dem Emitter des Transistors 33 verbunden ist. Der Kollektor des Transistors 38 liegt an der Basis des Transistors 33 und außerdem ist zu der Basis-Emitterstrecke des Transistors 33 ein Ableitwiderstand 39 parallelgeschaltet.

Eine weitere ähnliche Konfiguration ist an den Transistor 35 angeschlossen, und zwar liegt parallel zu dem Stromfühlerwiderstand 34 die Basis-Emitterstrecke eines PNP-Transistors 41, dessen Emitter mit dem Kollektor des Transistors 33 verbunden ist, während seine Basis an den Emitter des Transistors 35 angeschaltet ist. Der Kollektor des Transistors 41 führt zu der Basis des Transistors 35, dessen Basisemitterstrecke ebenfalls über einen weiteren Ableitwiderstand 42 geshuntet ist.

Von der Basis des Transistors 33 bzw. dem Kollektor des Transistors 38 führt ein Widerstand 43 zu einem damit in Serie geschalteten PTC-Widerstand 44, der thermisch mit dem Gehäuse des Transistors 33 gekoppelt ist. Das andere Ende des PTC-Widerstandes 44 ist mit dem Steckerstift 26d elektrisch verbunden.

Der Steckerstift 26e ist an einen PTC-Widerstand 45 angeschlossen, von wo die elektrische Verbindung über einen Widerstand 46 weiter zu dem Kollektor des Transistors 41 bzw. der Basis des Transistors 35 führt. Der PTC-Widerstand 35 ist thermisch fest mit dem Gehäuse des Transistors 35 gekoppelt.

Die Steckerstifte 26f...26i sind an ihren Lötfahnen 28 miteinander verbunden und liegen an einer Schaltungsmasse 47, an der auch die Last 37 mit ihrem kalten Ende angeschaltet ist.

Bei dem Steckverbinderteil 2 sind die in den Buchsensitzen 11a...11c enthaltenen Steckbuchsen 12 miteinander verbunden und über eine Leitung 48 beispielsweise mit dem Pluspol einer nicht gezeigten Stromquelle verbunden.

Die in den Buchsensitzen 11d...11f sitzenden Steckbuchsen 12 sind über eine Leitung 49 miteinander kurzgeschlossen, jedoch von allen übrigen Steckbuchsen 12 galvanisch getrennt. Schließlich sind auch die in den Buchsensitzen 11g...11i vorhandenen Steckbuchsen 12 miteinander galvansich verbunden und beispielsweise über eine Leitung 51 mit dem Minuspol der vorerwähnten gezeigten Stromquelle verbunden, wobei der Minuspol beispielsweise die Schaltmasse darstellt.

Die Funktionsweise der gezeigten Anordnung ist wie folgt:

Sobald der Steckverbinder 3 in den Steckverbinder 2 eingeführt wird, werden zunächst die Kontaktstifte 26a... 26c mit den zugehörigen Steckbuchsen 12 in dem Steckverbinder 2 und gleichzeitig die Kontaktstiften 26g...26i mit den korrespondierenden Steckbuchsen 12 eine galvanische Verbindung herstellen. Damit entsteht eine galvanische Verbindung zwischen der unter Spannung stehenden Leitung 48 und dem Eingang 30 der Schaltereinrichtung 4, gebildet durch die Schmelzsicherung 31 sowie zwischen der Leitung 51 und der Leitung 47.

Die Kontaktstifte 26d...26f werden anfänglich von den zugehörigen Steckbuchsen 12 noch getrennt sein. Dies bedeutet, dass weder der Transistor 33 noch der Transistor 35 an seiner Basis eine entsprechende negative Vorspannung bekommt. Vielmehr ist die jeweilige Basis über den Shuntwiderstand 39 bzw. 42 mit dem zugehörigen Emitter verbunden, so dass beide Transistoren 33 und 35 gesperrt sind. Die Ausgangsleitung 36 wird folglich stromlos sein und es kann kein Strom durch den Verbraucher 37 fließen; die Verbindung über den Verbraucher 37 d.h. der Hauptstromkreis ist unterbrochen.

Die Kontaktgabe zwischen den Kontaktstiften 26a...26c bzw. den Kontaktstiften 26g...26i mit den zugehörigen Steckbuchsen 12 wird folglich stromlos sein, womit auf keinen Fall ein Funke erzeugt werden kann.

Wenn der Steckverbinder 3 tiefer in den Steckverbinder 2 eingesteckt wird, gleiten ohne Stromunterbrechung die Kontaktstifte 26a...26c sowie 26g...26i zunehmend tiefer in die zugehörigen Steckbuchsen 12 ein. Ab einer bestimmten Einstecktiefe werden sodann auch die Steckerstifte 26d... 26f mit den zugehörigen Steckbuchsen in Berührung kommen und eine entsprechende galvanische Verbindung herstellen. Nachdem diese galvanische Verbindung hergestellt ist, entsteht ein Stromkreis von der Basis des Transistors 33 über den Widerstand 43, den PTC-Widerstand 44, den Steckerstift 26d zu der zugehörigen Steckbuchse 12, von dort über die Leitung 49 zu der Steckbuchse für den Steckerstift 26f und von hier zur Schaltungsmasse 47. Der fließende Steuerstrom steuert den Transistor 33 auf.

In ähnlicher Weise entsteht ein Basisstrom für den Transistor 35, indem ein aus der Basis des Transistors 35 über den Widerstand 46, den PTC-Widerstand 45, den Steckerstift 26e, die Leitung 49 zu dem Steckerstift 26f und wiederum zur Schaltungsmasse 47 fließt. Dadurch sind nunmehr beide Transistoren 33 und 35 niederohmig und der Ausgang 36 ist niederohmig mit den Steckerstiften 26a...26c verbunden. Der Hauptstromkreis ist damit freigegeben. Der Verbraucher bzw. die Last 37 kann nun Strom entnehmen.

Wenn im vollen Betrieb nun der Steckverbinder 3 von dem Steckverbinder 2 getrennt werden soll, beispielsweise weil das mit dem Steckverbinder 3 mechanisch gekoppelte Gerät, symbolisiert durch den Verbraucher 37, entfernt oder durch ein anderes Gerät ersetzt werden soll, braucht die Spannung auf den Leitungen 48 und 51 nicht zuvor abgeschaltet zu werden. Beim Herausziehen des Steckverbinders 3 wird als erstes die galvanische Verbindung an einem der Steckerstifte 26d...26f unterbrochen, während die Steckerstifte 26a...26c bzw. 26g...26i immer noch in den zugehörigen Steckbuchsen 12 stecken und die elektrische Verbindung herstellen.

Sobald einer der Steckerstifte 26d...26f die galvanische Verbindung mit der zugehörigen Steckbuchse 12 verliert, wird der Transistor 33 oder der Transistor 35 abgeschaltet oder es werden beide Transistoren gleichzeitig abgeschaltet, wenn als erstes der Steckerstift 26f aus der zugehörigen Steckbuchse 12 freikommt. Dadurch wird an dem Ausgang 36 die Spannung für den Verbraucher 37 abgeschaltet, d.h. es wird die Steckverbindung zwischen den beiden Steckverbindern 2 und 3 stromlos, obwohl nach wie vor eine galvanische Verbindung für den Hauptstromkreis besteht. Das anschließende mechanische Trennen der Steckerstifte 26a... 26c von den zugehörigen Steckbuchsen 12 bzw. der Steckerstifte 26g...26i von deren zugehörigen Steckbuchsen 12 kann, weil kein Strom mehr fließt, keinen elektrischen Funken mehr erzeugen.

Der Strom, der über die Steckerstifte 26d...26f beim Trennen fließt, ist so klein, dass ein Funken nicht hervorgerufen werden kann. Es genügt also, wenn die galvanischen Verbindungen an den Steckerstiften 26a...26c bzw. 26g...26i die Schutzvoraussetzungen der Schutzart "Erhöhte Sicherheit" oder "Eigensicherheit" erfüllen. "Druckfeste Kapselung" ist nicht notwendig.

Bei herausgezogenem Gerät sind die Transistoren 33 und 35 gesperrt. Ein in dem Verbraucher 37 vorhandener Kondensator kann keine Spannung an den Steckerstiften 26a...26c gegenüber den Steckerstiften 26g...26i hervorrufen.

Da die Basisvorspannung von der Masseleitung 47 auf der Seite des Steckverbinders 3 abgenommen wird, kann der Basisstrom auch nur dann fließen, wenn die Steckerstifte 26i...26g eine hinreichende galvanische Verbindung mit der Zuleitung 51 haben.

Im Normalbetrieb, d.h. unterhalb der zulässigen Stromgrenze, ist der Spannungsabfall an dem Stromfühlerwiderstand 32 kleiner als die Spannung, die erforderlich ist, um den Transistor 38 aufzusteuern, so dass der Transistor 33 durchgesteuert werden kann. Gleiches gilt für den Spannungsabfall an dem Widerstand 34, der ebenfalls kleiner ist als die Basis-Emitterspannung, die erforderlich ist, um den Transistor 41 durchzusteuern. Wenn der Strom jedoch eine vorher festgelegte Grenze übersteigt, wird an einem der beiden Transistoren 41 oder 38 der Spannungsabfall am zugehörigen Widerstand 34 bzw. 32 über den entsprechenden Grenzwert steigen und den zugehörigen Transistor 41 oder 38 aufsteuern. Der Transistor 38 oder 41, je nachdem, welcher früher aufsteuert, erzeugt einen Kurzschluss für die Basis-Emitterstrecke des Transistors 33 oder des Transistors 35, wodurch dieser in den Sperrzustand übergeht. Die Schaltereinrichtung 4 geht in den hochohmigen oder AUS-Zustand über und schaltet den Strom für die Last 37 ab.

Mit Hilfe der beiden PTC-Widerstände 44 und 45 wird die Temperatur des Transistors 33 sowie des Transistors 35 überwacht. Sollte z.B. die Temperatur des Transistors 33 auf einen zu hohen Wert ansteigen, wird der PTC-Widerstand 44, der mit diesem Transistor thermisch sehr eng gekoppelt ist, hochohmig, wodurch der Basisstrom gesperrt und der Transistor 33 abgeschaltet wird. In ähnlicher Weise arbeiten der Transistor 35 und der PTC-Widerstand 45 zusammen.

Die Bedingung "Erhöhte Sicherheit" oder "nicht störanfällige Verbindung" gemäß der Zündschutzart "Eigensicherheit" wird durch das Parallelschalten mehrerer Steckerstifte 26a...26c bzw. 26g...26i erreicht, denn es wird angenommen, dass bei einer Bewegung der Steckerstifte in den Steckbuchsen nicht an allen Kontaktstellen gleichzeitig Mikrounterbrechungen auftreten können, die zu Funken führen.

Eine andere Möglichkeit, die Bedingung "Erhöhte Sicherheit" oder "nicht störanfällige Verbindung" gemäß der Zündschutzart "Eigensicherheit" zu erreichen, besteht darin, beispielsweise die Steckbuchsen 12 als Multilamellenbuchsen auszubilden, die eine Vielzahl von gleichzeitigen Kontaktstellen bereitstellen.

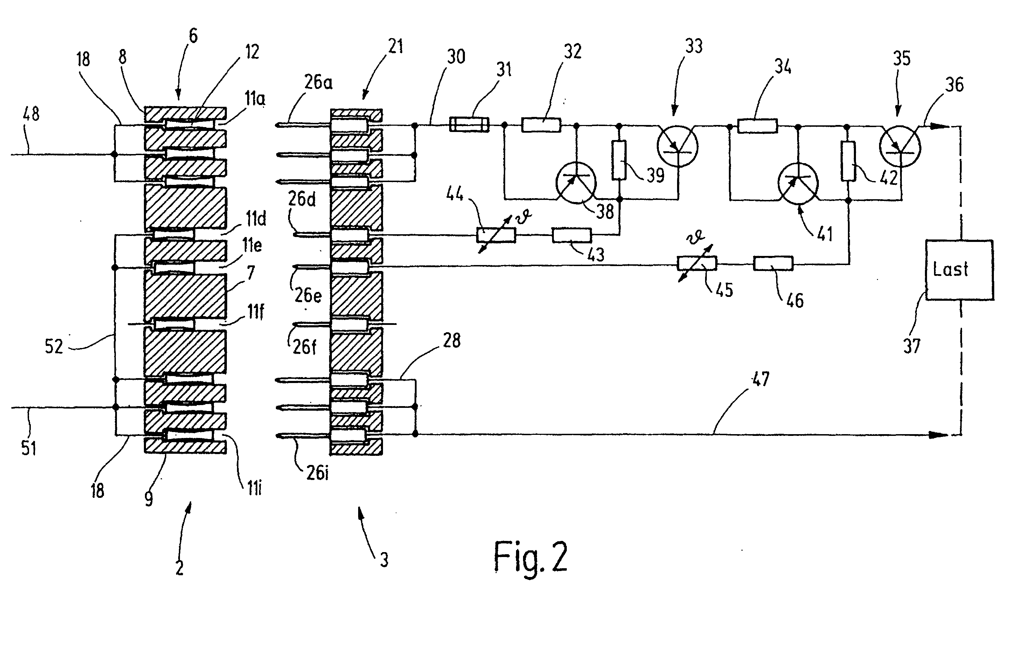

Fig. 2 zeigt eine Schaltungsanordnung, die sich von dem Ausführungsbeispiel nach Fig. 1 dadurch unterscheidet, dass die Kontaktbuchsen 12, die mit den Steckerstiften 26d und 26e zusammenwirken, über eine Leitung 52 direkt mit der Zuleitung 51 verbunden sind. Es kann der Steckerstift 26f eingespart werden, obwohl er in Fig. 2 noch veranschaulicht ist.

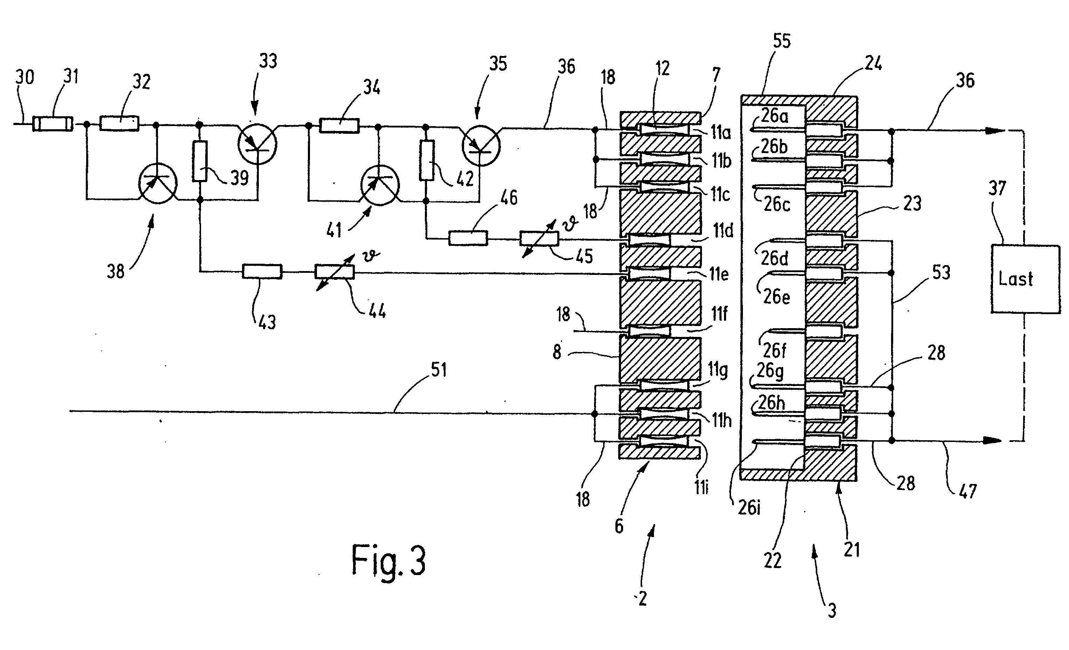

Das Ausführungsbeispiel nach Fig. 3 unterscheidet sich von den beiden vorherigen im Wesentlichen durch die Lage der Schaltereinrichtung 4. Sie befindet sich auf der Seite der Stromversorgung zwischen der Stromversorgung und dem Steckverbinder, während der Steckverbinder 3 galvanisch direkt an den Verbraucher 37 angeschlossen ist. Demzufolge liegt der Emitter des Transistors 35 an den Steckbuchsen 12 für die Steckerstifte 26a...26c. Die beiden PTC-Widerstände 44 und 45 sind entsprechend mit den Steckbuchsen 12 für die Steckerstifte 26d und 26e verbunden, während auf der Seite des Steckverbinders 3 die Steckerstifte 26d...26f über eine Leitung 52 direkt mit der Leitung 47 und damit den Steckerstiften 26g...26i verbunden sind.

Das elektrische Schaltverhalten der Schaltereinrichtung 4 beim Einstecken des Steckverbinders 3 in den Steckverbinder 2 ist sinngemäß das Gleiche, wie dies im Zusammenhang mit Fig. 1 sehr ausführlich erläutert ist. In jedem Falle wird die Leitung 36 erst dann stromführend, wenn auch die galvanische Verbindung mit den Steckerstiften 26d bzw. 26f hergestellt ist, so dass ein Basisstrom aus den Transistoren 33 und 35 zu der Leitung 47 fließen kann, die bereits vorab mit der Leitung 51 galvanisch verbunden wurde.

Um die Steckerstifte 26 mechanisch zu schützen, ist an dem Grundkörper 21 ein Schutzkragen 55 einstückig angeformt, der eine größere axiale Erstreckung hat als die Steckerstifte 26. Im eingesteckten Zustand übergreift er den Grundkörper 6 des Steckverbinders 2. Damit sind die beim Einführen in den Steckverbinder noch blank liegenden Abschnitte der Steckerstifte 26 geschützt.

Eine Steckverbindungsanordnung weist zwei Steckverbinderleisten auf, über die im zusammengesteckten Zustand der Strom von einer Stromquelle zu einem Verbraucher fließt. Zwischen einer Steckverbinderleiste und der Stromquelle bzw. dem Verbraucher sitzt eine Schaltereinrichtung, deren Steuersignal ebenfalls über die beiden Steckverbinderleisten führt. Die Kontakte für die Hauptstromkreise eilen vor, während die Kontakte für den Steuerstrom nacheilen, so dass die Hauptstromkreise bereits geschlossen sind, ehe der Steuerstromkreis eingeschaltet wird. Dadurch wird ein Stromfluss in den Hauptstromkreisen beim Stecken oder Trennen der Kontakte der Hauptstromkreise verhindert.

## Patentansprüche

1. Explosionsgeschützte Steckverbindungsanordnung (1) zwischen einer Stromversorgung und einem Verbraucher (37),
mit einem ersten Steckverbindungsteil (2), das wenigstens eine Steckbuchse (12) aufweist, die in einem Halterteil (6) angeordnet ist, das aus einem Isolierstoff besteht und deren Einstecköffnung (15) durch eine zugeordnete Zugangsöffnung in dem Halterteil (6) zugänglich ist,
mit einem zweiten Steckverbindungsteil (3), das wenigstens einen Steckerstift (26) aufweist, der in einem Halterteil (21) angeordnet ist, das aus einem Isolierstoff besteht,
mit wenigstens einer steuerbaren Schaltereinrichtung (4), die einen Eingang (30) und einen Ausgang (36) aufweist, die eingangsseitig an den wenigsten einen Steckerstift (26) oder ausgangsseitig an die wenigstens eine Steckbuchse (12) elektrisch angeschlossen ist und die zwei Schaltzustände aufweist, wobei in dem einen Schaltzustand die Schaltereinrichtung (4) zwischen ihrem Eingang (30) und ihrem Ausgang (36) hochohmig und in dem anderen Schaltzustand die Schaltereinrichtung (4) zwischen ihrem Eingang (30) und ihrem Ausgang (36) niederohmig ist,
mit einer einen Steuerstromkreis enthaltenden Steuereinrichtung (5), deren Steuersignal aus demjenigen Steckverbindungsteil (2,3) kommt, das der Schaltereinrichtung (4) nicht unmittelbar zugeordnet ist, wobei die Steuereinrichtung (5) derart gestaltet ist,
- dass sie die Schaltereinrichtung (4) erst dann in den niederohmigen Zustand bringt, wenn der wenigstens eine Steckerstift (26) mit der wenigstens einen Steckbuchse (12) eine elektrisch leitende Verbindung bildet, und
- dass sie die Schaltereinrichtung (4) bereits dann in den hochohmigen Zustand bringt, wenn beim Trennen der wenigstens eine Steckerstift (26) mit der wenigstens einen Steckbuchse (12) noch eine elektrisch leitende Verbindung bildet,
und **gekennzeichnet durch**
eine Überlastungsschutzeinrichtung (44,45;38,41), die zum Schutz der Schaltereinrichtung (4) vorgesehen ist.

2. Steckverbindungsanordnung nach Anspruch 1, **dadurch gekennzeichnet, dass** die Schaltereinrichtung (4) auf der Seite der Steckverbindungsanordnung (1) vorgesehen ist, die dem Verbraucher (37) entspricht.

3. Steckverbindungsanordnung nach Anspruch 1, **dadurch gekennzeichnet, dass** das erste Steckverbindungsteil (2) und das zweite Steckverbindungsteil (3) aufeinander abgestimmt sind.

4. Steckverbindungsanordnung nach Anspruch 1, **dadurch gekennzeichnet, dass** die wenigstens eine Steckbuchse (12) in dem ersten Steckverbindungsteil (2) berührungssicher angeordnet ist.

5. Steckverbindungsanordnung nach Anspruch 1, **dadurch gekennzeichnet, dass** das zweite Steckverbindungsteil (3) einen Kragen (55) aufweist, der den wenigstens einen Steckerstift (26) oder mehrere Steckerstifte (26) gemeinsam umgibt.

6. Steckverbindungsanordnung nach Anspruch 5, **dadurch gekennzeichnet, dass** der Kragen (55) eine Tiefe aufweist, die größer ist als die Länge des wenigstens einen Steckerstifts (26).

7. Steckverbindungsanordnung nach Anspruch 5, **dadurch gekennzeichnet, dass** der Kragen (55) an dem Halterteil (21) aus Isolierstoff einstückig angeformt ist.

8. Steckverbindungsanordnung nach Anspruch 1, **dadurch gekennzeichnet, dass** sie je elektrischer Verbindung zwischen der Stromversorgung und dem Verbraucher (37) wenigstens eine Steckbuchse (12) und einen zugehörigen Steckerstift (26) aufweist, wobei die Kombination die Schutzbedingungen "erhöhte Sicherheit" oder "nicht störanfällige Verbindung" gemäß der Zündschutzart "Eigensicherheit" erfüllt.

9. Steckverbindungsanordnung nach Anspruch 1, **dadurch gekennzeichnet, dass** sie je elektrischer Verbindung zwischen der Stromversorgung und dem Verbraucher (37) mehrere Steckbuchsen (12) und zugehörige Steckerstifte (26) aufweist, die elektrisch parallelgeschaltet sind, wobei keine der Kombinationen für sich alleine die Schutzbedingungen "erhöhte Sicherheit" oder "nicht störanfällige Verbindung" gemäß der Zündschutzart "Eigensicherheit" erfüllt.

10. Steckverbindungsanordnung nach Anspruch 1, **dadurch gekennzeichnet, dass** die Schaltereinrichtung (4) eine elektronische Schaltereinrichtung ist.

11. Steckverbindungsanordnung nach Anspruch 1, **dadurch gekennzeichnet, dass** die Schaltereinrichtung (4) redundant aufgebaut ist.

12. Steckverbindungsanordnung nach Anspruch 1, **dadurch gekennzeichnet, dass** die Schaltereinrichtung (4) wenigstens einen gesteuerten Halbleiter (33,35) mit Steuereingang als Schalter enthält.

13. Steckverbindungsanordnung nach Anspruch 1, **dadurch gekennzeichnet, dass** die Schaltereinrichtung (4) wenigstens zwei gesteuerten Halbleiter (33,35) mit Steuereingang als Schalter enthält.

14. Steckverbindungsanordnung nach Anspruch 1, **dadurch gekennzeichnet, dass** dem jeweiligen Steuereingang ein Steuerstromkreis zugeordnet ist, der zu der Steuereinrichtung (5) gehört, und dass der Steuerstromkreis (5) über die beiden Steckverbindungsteile (2,3) geschleift ist.

15. Steckverbindungsanordnung nach Anspruch 1, **dadurch gekennzeichnet, dass** der Steuerstromkreis (5) von dem zweiten Steckverbindungsteil (3) zu dem ersten Steckverbindungsteil (2) führt.

16. Steckverbindungsanordnung nach Anspruch 15, **dadurch gekennzeichnet, dass** der Steuerstromkreis (5) von dem ersten Steckverbindungsteil (2) zu dem zweiten Steckverbindungsteil (3) zurückgeschleift ist.

17. Steckverbindungsanordnung nach Anspruch 1, **dadurch gekennzeichnet, dass** die Steuereinrichtung (5) wenigstens eine Steuersteckbuchse (12) und wenigstens einen Steuersteckerstift (26d..f) für den Steuerstromkreis (5) aufweist und dass die Steuersteckbuchse (12) in dem ersten Steckverbindungsteil (2) und der Steuersteckerstift (26d..26f) in dem zweiten Steckverbindungsteil (3) enthalten ist.

18. Steckverbindungsanordnung nach Anspruch 17, **dadurch gekennzeichnet, dass** der Steuersteckerstift (26d..f) und die Steuersteckbuchse (12) derart in dem jeweiligen Halterteil (6,21) untergebracht sind, dass sie erst dann eine elektrische Verbindung herstellen, wenn die elektrische Verbindung über die wenigstens eine Steckbuchse (12) und den wenigstens einen Steckerstift (26) bereits besteht.

19. Steckverbindungsanordnung nach Anspruch 1, **dadurch gekennzeichnet, dass** der Steuerstromkreis (5) wenigstens einen Sensor (44,45) enthält.

20. Steckverbindungsanordnung nach Anspruch 19, **dadurch gekennzeichnet, dass** der Sensor (44,45) ein Temperatursensor ist.

21. Steckverbindungsanordnung nach Anspruch 20, **dadurch gekennzeichnet, dass** der Temperatursensor (44,45) mit der Schaltereinrichtung (4) thermisch gekoppelt ist.

22. Steckverbindungsanordnung nach Anspruch 1, **dadurch gekennzeichnet, dass** in Serie mit der Schaltereinrichtung (4) ein Stromsensor (32,34) liegt und der Schaltereinrichtung (4) eine Begrenzereinrichtung (38,41) zugeordnet ist, durch die die Schaltereinrichtung (4) beim Überschreiten eines Stromgrenzwertes gesperrt wird.

23. Steckverbindungsanordnung nach Anspruch 1, **dadurch gekennzeichnet, dass** die Stromversorgung ein Teil eines Bus und der Verbraucher ein an den Bus angeschlossenes Gerät ist.

## Claims

1. Explosion-proof plug connector arrangement (1) between a power supply and a load (37),
with a first plug connector part (2), which has at least one socket (12), which is disposed in a holder part (6) made of an insulating material, and the plug-in opening (15) of which is accessible through an associated access opening in the holder part (6),
with a second plug connector part (3), which has at least one plug pin (26), which is disposed in a holder part (21) made of an insulating material,
with at least one controllable switch means (4), which has an inlet (30) and an outlet (36), is electrically connected on the inlet side to the at least one plug pin (26) or on the outlet side to the at least one socket (12), and has two switching statuses, wherein in one switch status the switch means (4) is high-impedance between its inlet (30) and its outlet (36) and in the other switch status the switch means (4) is low-impedance between its inlet (30) and its outlet (36),
with a control means (5) containing a control circuit, the control signal of which comes from the plug connector part (2, 3) which is not directly associated with the switch means (4), wherein configuration of the control means (5) is such:
- that it only brings the switch means (4) into the low-impedance status when the at least one plug pin (26) forms an electrically conductive connection with the at least one socket (12), and
- that it already brings the switch means (4) into the high-impedance status when it is still forming an electrically conductive connection with the at least one socket (12) on disconnection of the at least one plug pin (26),
and **characterised by** an overload protection means (44, 45; 38, 41) which is provided to protect the switch means (4).

2. Plug connector arrangement according to Claim 1, **characterised in that** the switch means (4) is provided on the side of the plug connector arrangement (1) which corresponds to the load (37).

3. Plug connector arrangement according to Claim 1, **characterised in that** the first plug connector part (2) and the second plug connector part (3) are coordinated to one another.

4. Plug connector arrangement according to Claim 1, **characterised in that** the at least one socket (12) is disposed in the first plug connector part (2) in a manner protected from contact.

5. Plug connector arrangement according to Claim 1, **characterised in that** the second plug connector part (3) has a collar (55), which surrounds the at least one plug pin (26) or several plug pins (26) jointly.

6. Plug connector arrangement according to Claim 5, **characterised in that** the collar (55) has a depth which is greater than the length of the at least one plug pin (26).

7. Plug connector arrangement according to Claim 5, **characterised in that** the collar (55) is moulded in one piece on the holder part (21) made of insulating material.

8. Plug connector arrangement according to Claim 1, **characterised in that** for each electrical connection between the power supply and the load (37), it has at least one socket (12) and an associated plug pin (26), wherein the combination meets the protection conditions "increased safety" or "non fault-prone connection" in accordance with the protection type "intrinsic safety".

9. Plug connector arrangement according to Claim 1, **characterised in that** for each electrical connection between the power supply and the load (37), it has at several sockets (12) and associated plug pins (26), which are electrically connected in parallel, wherein none of the combinations alone meets the protection conditions "increased safety" or "non fault-prone connection" in accordance with the protection type "intrinsic safety".

10. Plug connector arrangement according to Claim 1, **characterised in that** the switch means (4) is an electronic switch means.

11. Plug connector arrangement according to Claim 1, **characterised in that** the switch means (4) is of redundant configuration.

12. Plug connector arrangement according to Claim 1, **characterised in that** the switch means (4) includes at least one semiconductor (33, 35) with control input as the switch.

13. Plug connector arrangement according to Claim 1, **characterised in that** the switch means (4) includes at least two semiconductors (33, 35) with control input as the switch.

14. Plug connector arrangement according to Claim 1, **characterised in that** a control circuit belonging to the control means (5) is assigned to the respective control input, and that the control circuit (5) is looped over the two plug connector parts (2, 3).

15. Plug connector arrangement according to Claim 1, **characterised in that** the control circuit (5) leads from the second plug connector part (3) to the first plug connector part (2).

16. Plug connector arrangement according to Claim 1, **characterised in that** the control circuit (5) loops back from the first plug connector part (2) to the second plug connector part (3).

17. Plug connector arrangement according to Claim 1, **characterised in that** the control means (5) has at least one control connector socket (12) and at least one control plug pin (26d ..f) for the control circuit (5), and that the control connector socket (12) is contained in the first plug connector part (2) and the control plug pin (26d..f) is contained in the second plug connector part (3).

18. Plug connector arrangement according to Claim 17, **characterised in that** the control plug pin (26d ..f) and the control connector socket (12) are housed in the respective holder part (6, 21) in such a way that they only generate an electrical connection when the electrical connection via the at least one socket (12) and the at least one plug pin (26) already exists.

19. Plug connector arrangement according to Claim 1, **characterised in that** the control circuit (5) contains at least one sensor (44, 45).

20. Plug connector arrangement according to Claim 19, **characterised in that** the sensor (44, 45) is a temperature sensor.

21. Plug connector arrangement according to Claim 20, **characterised in that** the temperature sensor (44, 45) is thermally coupled to the switch means (4).

22. Plug connector arrangement according to Claim 1, **characterised in that** a current sensor (32, 34) is in series with the switch means (4) and a limiter means (38, 41) is assigned to the switch means (4) for locking the switch means (4) when a power limit value is exceeded.

23. Plug connector arrangement according to Claim 1, **characterised in that** the power supply is a part of a bus and the consumer device is a device connected to the bus.

## Revendications

1. Dispositif de connexion enfichable (1) anti-explosion, entre une alimentation en courant électrique et un utilisateur (37),
avec un premier élément de connecteur enfichable (2), présentant au moins une douille de connecteur (12), qui est disposée dans un élément support (6) en matériau isolant et dont l'ouverture d'enfichage (15) est accessible à travers une ouverture d'accès dans l'élément support (6),
avec un second élément de connecteur enfichable (3), qui présente au moins une broche de connecteur (26), qui est disposée dans un élément support (21) en matériau isolant,
avec au moins un dispositif commutateur (4) commandable, qui présente une entrée (30) et une sortie (36), qui est connecté électriquement à la broche de connecteur (26) au nombre d'au moins une, ou côté sortie à la douille de connecteur (12) au nombre d'au moins une, et présente deux états de commutation, dans un état de commutation, le dispositif commutateur (4) étant à forte valeur ohmique entre son entrée (30) et sa sortie (36) et dans l'autre état de commutation, le dispositif commutateur (4) étant à faible valeur ohmique entre son entrée (30) et sa sortie (36),
avec un dispositif de commande comportant un circuit de courant de commande, dont le signal de commande provient de l'élément de connecteur enfichable qui n'est pas directement associé au dispositif commutateur (4), le dispositif de commande (5) étant agencé de telle sorte
qu'il amène le dispositif commutateur (4) à l'état de faible valeur ohmique seulement lorsque la broche de connecteur (26) au nombre d'au moins une, réalise une liaison électro-conductrice avec la douille de connecteur (12) au nombre d'au moins une, et
qu'il amène le dispositif commutateur (4) à l'état de forte valeur ohmique lorsque, lors de la séparation, la broche de connecteur (26) au nombre d'au moins une, assure encore une liaison électro-conductrice avec la douille de connecteur (12) au nombre d'au moins une,
**caractérisé par** un dispositif de protection contre les surcharges (44, 45; 38, 41) qui est prévu pour protéger le dispositif commutateur (4).

2. Dispositif de connexion enfichable selon revendication 1, **caractérisé par le fait que** le dispositif commutateur (4) est prévu du côté du dispositif de connexion enfichable (1) qui correspond à l'utilisateur (37).

3. Dispositif de connexion enfichable selon revendication 1, **caractérisé par le fait que** le premier élément de connecteur (2) et le second élément de connecteur (3) sont mutuellement adaptés.

4. Dispositif de connexion enfichable selon revendication 1, **caractérisé par le fait que** la douille de connecteur (12) au nombre d'au moins une dans le premier élément de connecteur (2) est protégée contre les contacts intempestifs.

5. Dispositif de connexion enfichable selon revendication 1, **caractérisé par le fait que** le second élément de connecteur (3) comporte un collet (55), qui entoure la broche de connecteur (26) au nombre d'au moins une ou plusieurs broches de connecteur (26) simultanément.

6. Dispositif de connexion enfichable selon revendication 5, **caractérisé par le fait que** le collet (55) a une profondeur qui est supérieure à la longueur de la broche de connecteur (26) au nombre d'au moins une .

7. Dispositif de connexion enfichable selon revendication 5, **caractérisé par le fait que** le collet (55) est formé d'une pièce avec l'élément support (21) en un matériau isolant.

8. Dispositif de connexion enfichable selon revendication 1, **caractérisé par le fait qu'**elle présente pour chaque liaison électrique entre l'alimentation électrique et l'utilisateur (37), au moins une douille de connecteur (12) et une broche de connecteur (26) associée, la combinaison remplissant les exigences de protection "Sécurité élevée" ou "Liaison sécurisée contre les perturbations" conformément à la classe de protection "A protection intrinsèque".

9. Dispositif de connexion enfichable selon revendication 1, **caractérisé par le fait qu'**elle présente pour chaque liaison électrique entre l'alimentation électrique et l'utilisateur (37), plusieurs douilles de connecteur (12) et des broches de connecteur (26) associées, qui sont connectées électriquement en parallèle, la combinaison remplissant les exigences de protection "Sécurité élevée" ou "Liaison sécurisée contre les perturbations" conformément à la classe de protection "A protection intrinsèque".

10. Dispositif de connexion enfichable selon revendication 1, **caractérisé par le fait que** le dispositif commutateur (4) est un dispositif-commutateur électronique

11. Dispositif de connexion enfichable selon revendication 1, **caractérisé par le fait que** le dispositif commutateur (4) présente une structure redondante.

12. Dispositif de connexion enfichable selon revendication 1, **caractérisé par le fait que** le dispositif commutateur (4) comporte au moins un semi-conducteur (33, 35) commandé avec une entrée de commande comme commutateur.

13. Dispositif de connexion enfichable selon revendication 1, **caractérisé par le fait que** le dispositif commutateur (4) comporte au moins deux semi-conducteurs (33, 35) commandé avec une entrée de commande comme commutateur.

14. Dispositif de connexion enfichable selon revendication 1, **caractérisé par le fait qu'**à l'entrée de commande concernée est associé un circuit de courant de commande qui fait partie du dispositif de commande (5) et en ce que le circuit de courant de commande (5) est bouclé sur les deux éléments de connecteur (2, 3).

15. Dispositif de connexion enfichable selon revendication 1, **caractérisé par le fait que** le circuit de courant de commande (5) mène du deuxième élément de connecteur (3) au premier élément de connecteur (2).

16. Dispositif de connexion enfichable selon revendication 15, **caractérisé par le fait que** le circuit de courant de commande (5) est bouclé du premier élément de connecteur (2) vers le deuxième élément de connecteur (3).

17. Dispositif de connexion enfichable selon revendication 1, **caractérisé par le fait que** le dispositif de commande (5) présente au moins une douille de connecteur de commande (12) et au moins une broche de connecteur de commande (26d ...f) pour le circuit de courant de commande (5) et en ce que la douille de connecteur de commande (12) est contenue dans le premier élément de connecteur enfichable (2) et la broche de connecteur de commande (26d...f) dans le second élément de connecteur enfichable (2).

18. Dispositif de connexion enfichable selon revendication 17, **caractérisé par le fait que** la broche de connecteur de commande (26d ...f) et la douille de connecteur de commande (12) sont logées dans l'élément support (6, 21) concerné de telle sorte qu'ils ne réalisent une liaison électrique que lorsque la liaison électrique entre la douille de connecteur (12) au nombre d'au moins une et la broche de connecteur (26) au nombre d'au moins une est établie.

19. Dispositif de connexion enfichable selon revendication 1, **caractérisé par le fait que** le circuit de courant de commande (5) comprend au moins un capteur (44, 45).

20. Dispositif de connexion enfichable selon revendication 19, **caractérisé par le fait que** le capteur (44, 45) est un capteur de température.

21. Dispositif de connexion enfichable selon revendication 20, **caractérisé par le fait que** le capteur (44, 45) de température est couplé thermiquement au dispositif commutateur (4).

22. Dispositif de connexion enfichable selon revendication 1, **caractérisé par le fait qu'**un détecteur de courant (32, 34) est connecté en série avec le dispositif commutateur (4) et qu'un dispositif limiteur (38, 41), par lequel le dispositif commutateur (4) est bloqué en cas de dépassement d'un seuil de courant, est associé au dispositif commutateur (4).

23. Dispositif de connexion enfichable selon revendication 1, **caractérisé par le fait que** l'alimentation en courant est une partie d'un bus et l'utilisateur un appareil connecté au bus.
